Europäisches Patentamt

European Patent Office

Office européen des brevets

(11) Numéro de publication: **0 230 826 B1**

# FASCICULE DE BREVET EUROPEEN

(45) Date de publication de fascicule du brevet:
**12.06.91**

(21) Numéro de dépôt: **86402858.4**

(22) Date de dépôt: **19.12.86**

(51) Int. Cl.⁵: **H03L 7/18, G06J 1/00**

(54) Synthétiseur numérique de fréquences élevées, à correction apériodique optimalisant la pureté spectrale.

(30) Priorité: **23.12.85 FR 8519067**

(43) Date de publication de la demande:
**05.08.87 Bulletin 87/32**

(45) Mention de la délivrance du brevet:
**12.06.91 Bulletin 91/24**

(84) Etats contractants désignés:
**DE GB IT**

(56) Documents cités:
**EP-A- 0 147 307**
**FR-A- 2 431 800**
**US-A- 4 144 579**
**US-A- 4 185 247**

(73) Titulaire: **THOMSON-CSF**
**51, Esplanade du Général de Gaulle**
**F-92800 Puteaux(FR)**

(72) Inventeur: **Dartois, Luc**
**THOMSON-CSF SCPI 19, avenue de Messine**
**F-75008 Paris(FR)**
Inventeur: **Riboni, Raymond**
**THOMSON-CSF SCPI 19, avenue de Messine**
**F-75008 Paris(FR)**
Inventeur: **Roullet, André**
**THOMSON-CSF SCPI 19, avenue de Messine**
**F-75008 Paris(FR)**

(74) Mandataire: **Lincot, Georges et al**
**THOMSON-CSF SCPI**
**F-92045 PARIS LA DEFENSE CEDEX 67(FR)**

EP 0 230 826 B1

## Description

La présente invention concerne un synthétiseur numérique de fréquences élevées, à correction apériodique optimalisant la pureté spectrale.

Elle s'applique notamment à la réalisation d'émetteurs récepteurs à évasion de fréquence, aux modulateurs démodulateurs des systèmes de transmission numérique ainsi qu'à la réalisation des systèmes de radiographie faisant application de la résonance magnétique nucléaire. Dans ces applications la synthèse des signaux d'horloge est obtenue à l'aide de synthétiseurs de fréquences ayant des temps d'acquisition de fréquence très brefs et de très bonnes résolutions en fréquence. Seuls les synthétiseurs de fréquence faisant application des méthodes de synthèse directe permettent d'obtenir ces résultats.

La contrepartie des grandes vitesses obtenues par la méthode de synthèse numérique directe est que les signaux d'horloge fournis par les synthétiseurs de fréquence correspondants ont une pureté spectrale réduite par la présence de raies parasites d'énergie -50 à -60 dBc et un bruit important. Egalement les synthétiseurs de fréquence faisant applications de cette méthode possèdent une fréquence maximale de fonctionnement relativement faible de l'ordre de quelques mégahertz. Ors, pour de nombreuses applications, ces performances apparaissent nettement insuffisantes et ne permettent pas en particulier de résoudre les problèmes de proximité en radiotélécommunications. D'autre part, pour garder une grande vitesse de synthèse en haute fréquence (HF, VHF, UHF) les boucles d'addition et de recopie doivent posséder des bandes larges et sont de ce fait peu efficaces en tant que filtres. Comme toute fréquence synthétisée conduit à un spectre de raies parasites, les synthétiseurs de fréquence utilisant les méthodes de synthèse direct sont munis de dispositifs qui permettent à la fois d'atténuer le bruit et l'amplitude des raies parasites.

Un dispositif de ce type est par exemple décrit dans le brevet US-A-4 144 579, mais il ne permet pas d'obtenir une grande pureté spectrale du fait que l'erreur de phase est déterminée par une différence de tension mesurée entre un cumul d'incrément de phase fourni par un registre accumulateur et un signal de rampe fourni par un circuit intégrateur de la différence de tension mesurée.

Un autre dispositif de ce type est aussi décrit dans le brevet US-A-4 185 247. Le synthétiseur de fréquence direct qui y est décrit comprend un accumulateur piloté par une fréquence d'horloge qui est la plus grande possible vis-à-vis de la fréquence a synthétiser. Cette dernière est fournie par le débordement pseudo-périodique de l'accumulateur. Cette pseudo-périodicité fournit une modulation de phase parasite qui est connue et qui est constituée par le résidu de l'accumulateur exprimé en fraction de l'horloge synthétisée. Ceci permet à l'aide d'un convertisseur numérique analogique de réaliser une modulation inverse de la modulation parasite et de réduire les raies parasites. Ces résultats sont obtenus à l'aide d'un système de correction de phase qui est réalisé à l'aide soit d'un déphaseur accordé contenant des diodes à capacité variables connues sous le nom de "varicaps" soit à l'aide de boucles rapides contenant un oscillateur controlé en tension dans la boucle duquel on injecte la modulation de correction. Ces systèmes de correction de phase ont pour inconvénients de posséder une faible linéarité, de n'être pas apériodiques et de n'être pas stables climatiquement, d'autre part, ils ne permettent pas de synthétiser des fréquences au delà de l'octave avec une linéarité inférieure au 1 %. Au plan de la réalisation décrite dans le brevet US précité, la fréquence maximale synthétisable apparaît être la moitié de celle du convertisseur numérique analogique employée pour effectuer la correction. De plus les additionneurs, compteurs et accumulateurs employés sont tels que leur vitesse décroit quand leur taille augmente c'est-à-dire quand la résolution ou le pas de synthèse devient de plus en plus fin.

Selon d'autres variantes de réalisation décrites, par exemple, dans le brevet GB-A-2 026 268 ou encore dans le brevet français FR-A-2.431.800, le niveau des raies résiduelles non corrigées est atténué en modulant l'incrément de phase de l'accumulateur sur les digits non corrigés par le convertisseur numérique analogique. Mais cette atténuation s'effectue au détriment du bruit et de toute façon, la même puissance de modulation globale (raie + bruit) se retrouve à la sortie de ces dispositifs.

Le but de l'invention est de pallier les inconvénients précités.

A cet effet, l'invention a pour objet, selon la revendication 1, un synthétiseur numérique de fréquence à corrections apériodiques optimalisant la pureté spectrale à grande précision temporelle caractérisé en ce qu'il comprend :

- un générateur de signaux d'horloge de référence de fréquence $F_c$
- un dispositif de calcul qui à partir d'un incrément de fréquence du signal à synthétiser fournit d'une part, des impulsions de fréquence $F_{sj}$ non corrigées décalées dans le temps par rapport au signal de fréquence $F_s$ à synthétiser d'une quantité $\Delta t$ au plus égale à $1/F_c$ et d'autre part, un signal d'erreur de temps correspondant au décalage de temps $\Delta t$ et un circuit de correction couplé au dispositif de calcul pour retarder les impulsions de signal $F_{sj}$ d'une durée maximale lorsque le signal d'erreur de

2

temps est nul et d'une quantité égale à la durée maximale diminuée du décalage $\Delta t$ indiqué par le signal d'erreur de temps, ledit dispositif de calcul comprenant au moins un registre accumulateur, incrémenté à pas constant à la fréquence de référence $F_c$, les impulsions de fréquence $F_{sj}$ étant obtenues sur la sortie de débordement du registre accumulateur chaque fois que la capacité maximale du registre accumulateur est atteinte, et ayant une sortie D pour initialiser après chaque instant de débordement le circuit de correction par le contenu du registre accumulateur représentant à cet instant le signal d'erreur de temps.

L'invention a également pour objet un synthétiseur selon la revendication 7.

Le synthétiseur selon l'invention a pour avantages qu'il permet d'obtenir une grande pureté spectrale et une adaptation automatique de la partie du résidu à fournir au circuit de correction d'écart de temps en fonction de la fréquence synthétisée. D'autre part, l'architecture du circuit est facilement intégrable sous la forme d'un composant intégré et le circuit de correction d'écart de temps qui est du type à retard d'impulsion, assure une très bonne linéarité, une bonne stabilité climatique et une apériodicité totale.

Le procédé de synthèse employé permet de synthétiser des fréquences allant du pas du synthétiseur jusqu'à celle du convertisseur numérique analogique et permet donc de gagner une octave par rapport aux performances des circuits connus en couvrant toute cette plage de fonctionnement avec le même circuit de correction d'écart de temps.

D'autres caractéristiques et avantages de l'invention apparaîtront à l'aide de la description qui va suivre et faite en regard des figures annexées qui représentent :

la figure 1 un schéma synoptique du synthétiseur direct de fréquence selon l'invention,

la figure 2 les détails de réalisation et le principe de base d'un circuit accumulateur de phase rapide utilisé pour la mise en oeuvre de l'invention,

la figure 3 les détails de réalisation des circuits analogiques permettant la correction linéaire et apériodique d'écart de temps selon l'invention,

la figure 4 un détail des chronogrammes et formes des signaux explicitant le fonctionnement du circuit de correction de la figure 3.

la figure 5 une généralisation du circuit de la figure 2 lorsque la plage de synthèse est quelconque,

la figure 6 un diagramme illustrant le niveau des raies résiduelles obtenues sur plusieurs octaves suivant que le circuit utilisé est le circuit simple de la figure 2 ou celui plus complexe de la figure 5.

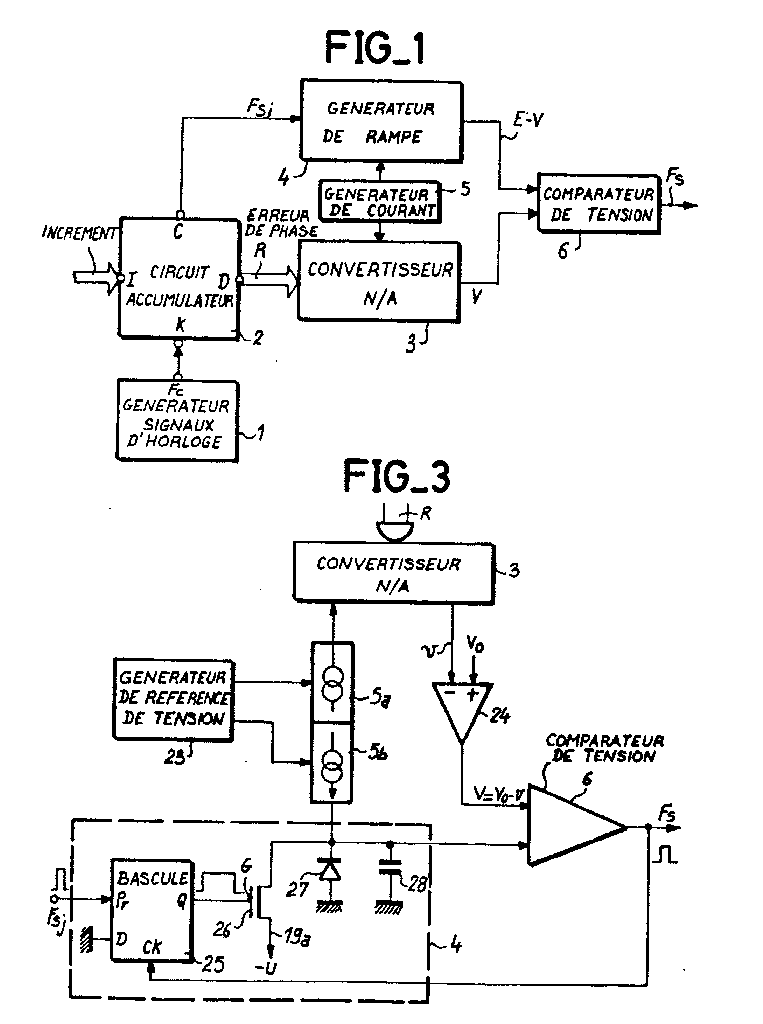

Le synthétiseur selon l'invention qui est représenté suivant le schéma de principe de la figure 1 comprend un générateur 1 de signal d'horloge de fréquence fixe $F_c$, un circuit accumulateur 2, un convertisseur numérique analogique 3, un générateur de rampe 4, un générateur de courant de référence 5, et un circuit de comparaison 6. Le générateur 1 de fréquence fixe est relié à l'entrée d'horloge marquée k du circuit accumulateur 2. Le circuit accumulateur 2 comprend une entrée I sur laquelle est appliqué un incrément de phase servant à augmenter le contenu du registre accumulateur à chaque impulsion d'horloge fournie par le générateur 1. Le circuit accumulateur 2 comprend également une sortie C de débordement qui délivre une impulsion $F_{sj}$ représentant la fréquence synthétisée, non corrigée, chaque fois que le registre accumulateur atteint sa capacité maximale, et une sortie D pour appliquer le contenu du circuit accumulateur à l'entrée du convertisseur numérique analogique 3.

La sortie de débordement C du circuit accumulateur est reliée à une entrée du générateur de rampe 4 qui fournit un signal en dent de scie à chaque fois qu'une impulsion apparaît sur la sortie de débordement C du circuit accumulateur 2. Le convertisseur numérique analogique 3 et le générateur de rampe 4 sont alimentés par un générateur de courant de référence 5. Les sorties du convertisseur numérique analogique 3, et du générateur de rampe 4, sont reliées respectivement à une première et une deuxième entrée de comparaison du comparateur de tension 6 qui fournit sur sa sortie le signal d'horloge synthétisé.

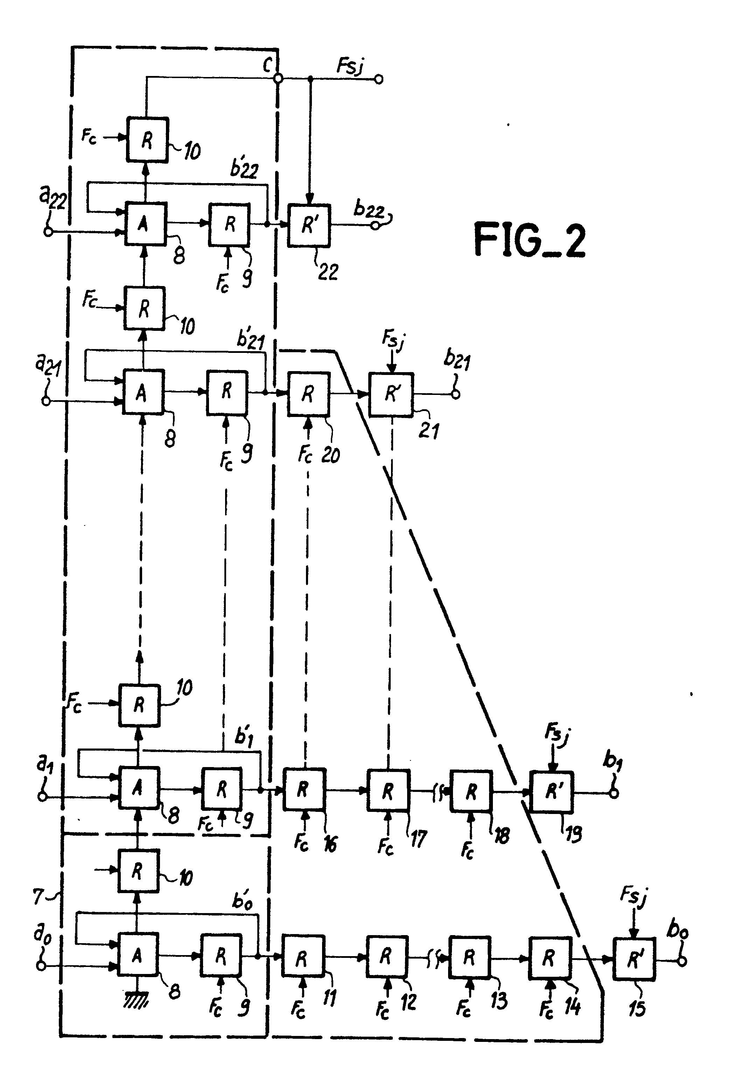

Un mode de réalisation du circuit accumulateur 2 est représenté à la figure 2. Ce mode de réalisation permet d'augmenter la vitesse du circuit accumulateur 2, dans la technologie où il est réalisé et permet de rendre maximal le rapport de la fréquence d'horloge $F_c$ à la fréquence maximale de synthèse $F_S$ ce qui permet de réduire le niveau de modulation parasite sur la sortie C de débordement et autorise la synthèse de fréquences plus élevées. Le circuit accumulateur représenté est constitué par un nombre déterminé d'accumulateurs élémentaires de 1 bit, du type représenté en 7 à l'intérieur d'une ligne en pointillés sur la figure 2, comprenant un circuit additionneur 8, un registre de 1 bit 9 relié directement à la sortie de l'additionneur 8 et un registre de retenue 10 relié directement à la sortie de retenue du circuit additionneur 8. Sur la figure, le bit d'incrément $a_0$ appliqué sur une première entrée de l'additionneur 8 est ajouté au contenu du registre 9 qui est appliqué au rythme de la fréquence $F_c$ sur la deuxième entrée d'opérande de l'additionneur 8. La retenue, si elle existe, est propagée à l'intérieur du registre 10. Les résultats des additions et les reports éventuels sont propagés respectivement dans les registres 9 et 10 à la fréquence du signal d'horloge $F_c$ fourni par le générateur 1. Le circuit accumulateur qui est représenté a une capacité

de $2^{23}$. Il est constitué dans ces conditions par 23 circuits additionneurs 7 mis en cascade. La retenue sortant de chaque circuit est appliquée à l'entrée de débordement du circuit suivant. Il faut par conséquent 23 cycles d'horloge à la fréquence $F_c$ pour obtenir sur la sortie de débordement C l'impulsion du signal d'horloge synthétisée $F_{sj}$ non corrigée, chaque nouvelle accumulation démarrant à chaque période du signal d'horloge de fréquence $F_c$.

Les bits $b'_0$ à $b'_{22}$ formant le contenu de l'accumulateur utile aux corrections de phase ne sortent pas simultanément des additionneurs 9 mais sont tous décalés. $b'_{22}$ est en phase avec la retenue $F_{sj}$ en sortant de l'accumulateur poids fort. $b'_{21}$ est en avance de

$$\frac{1}{F_c}$$

et ainsi de suite $b'_i$ est en avance de

$$\frac{(22-i)}{F_c}$$

par rapport à $F_{sj}$.

Pour réaliser une correction correcte il faut remettre en phase tous ces bits et les faire coïncider avec $F_{sj}$ afin d'alimenter le convertisseur avec des bits $b_i$ stables et cohérents. Chaque bit $b'_i$ doit être retardé de

$$\frac{(22-i)}{F_c}$$

soit 22-i coups d'horloge $F_c$. Ceci est réalisé à l'aide d'une matrice de registres 1 bit, 11 à 20. Chaque bit $b_i$ passe dans (22-i) registres soit dans le cas présent une matrice de

$$\frac{22 \times 21}{2} = 231$$

registres identiques au circuit 9 ou 10. Les bits $b_i$ obtenus sont alors échantillonés par l'impulsion $F_{sj}$ grâce à 22 registres 15 à 21 identiques aux registres 9 et 10. Le mot de 23 bits forme l'erreur de phase sur l'impulsion $F_{sj}$ correspondant, ce mot est stable jusqu'à l'impulsion suivante et permet de commander le convertisseur. Un des avantages de cet accumulateur est sa structure très simple et régulière permettant une intégration facile et un emploi optimal de la vitesse d'une technologie donnée.

L'additionneur élémentaire type 8 peut être rendu plus rapide en faisant 2 demi additionneurs commutés. En effet pour un incrément de phase donné l'entrée $a_i$ de l'additionneur ne change pas. Seule varie la retenue et l'entrée $b'_i$.

Par ailleurs en technologie MOS, il est possible d'utiliser des circuits dynamiques du fait de l'horloge $F_c$ permanente et rapide. Par exemple, on peut réaliser des registres du type à transfert de charge permettant une grande densité d'intégration.

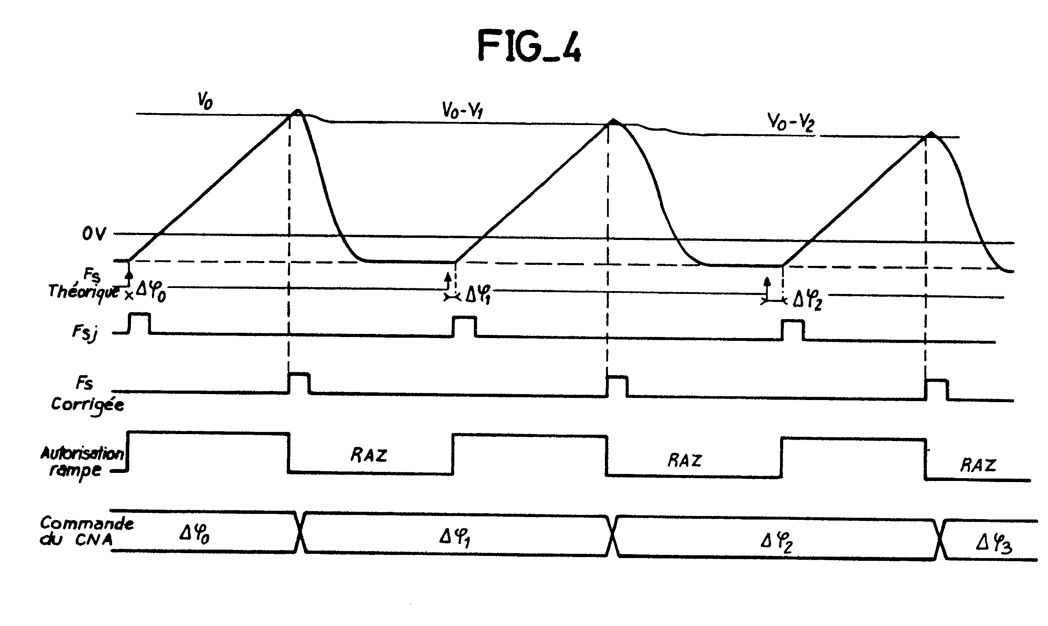

Les bits $b_0$ à $b_{22}$ de correction lus dans les registres 15 à 22 sont appliqués à l'entrée du convertisseur numérique analogique 3 qui est couplé au générateur de rampe 4 et au comparateur de tension 6 de la façon représentée à la figure 3. Sur cette figure un générateur de référence de tension 23 fournit des tensions de référence à deux générateurs de courant constant 5a et 5b qui appliquent, respectivement, un courant constant pour alimenter le convertisseur numérique analogique 3 et le générateur de rampe 4, dont les détails de réalisation sont représentés à l'intérieur d'un rectangle en pointillés. Un circuit soustracteur 24, formé par un amplificateur opérationnel ou tout dispositif équivalent, reçoit sur une première entrée d'opérande une tension de référence V0 constante. Ce circuit est couplé sur une deuxième entrée d'opérande à la sortie du convertisseur numérique analogique 3. Le circuit soustracteur 24 fournit la différence de tension V = V0 - v entre la tension de référence V0 et la tension v fournie par la sortie du convertisseur numérique analogique 3 qui représente l'erreur de phase lue dans les registres 15 à 22. Cette différence de tension V est appliquée sur une première entrée de comparaison du comparateur de tension 6. Le générateur de rampe 4 est constitué par une bascule D,25 qui est couplée sur son entrée de mise à 1 à la sortie C de débordement du circuit accumulateur 2 et est relié par sa sortie Q à la grille d'un transistor à effet de champ 26 dont la source est polarisée à un potentiel de référence et dont le drain est alimenté par la source de courant 5b. L'électrode de drain est d'autre part reliée au circuit de masse du générateur de rampe au travers d'une diode 27 et d'un condensateur 28 reliés en parallèle. Cette électrode est également reliée à la deuxième entrée de comparaison du comparateur de tension 6. La sortie du comparateur de tension 6 est rebouclée sur l'entrée d'horloge de la bascule D,25.

Le fonctionnement du synthétiseur de signaux d'horloge est le suivant. En revenant à la figure 1, le principe de base appliqué par l'invention consiste à réaliser, à l'aide du circuit accumulateur 2 formé de plusieurs accumulateurs élémentaires montés en cascade de la façon représentée à la figure 2, l'horloge de synthèse désirée à la bonne fréquence $F_S$ à partir du bit de retenue de débordement apparaissant sur la sortie C du circuit accumulateur 2. Ce bit est une impulsion ayant pour durée une période de l'horloge $F_c$ de l'accumulateur. Le signal d'horloge $F_{Sj}$ fourni par la sortie C est modulé en phase selon une dent de scie et l'amplitude de cette modulation est en écart de temps égal $1/F_c$ ce qui correspond à un écart de phase de

$$\frac{2\pi F_S}{F_c}.$$

La correction de cette modulation est effectuée à l'aide du circuit de correction analogique formé par le générateur de rampe 4, le convertisseur numérique analogique 3 et le comparateur de tension 6. Elle consiste dans un premier temps à déterminer l'erreur de phase entre le signal de fréquence FSJ et le signal $F_S$ que l'on cherche à obtenir. Cette erreur de phase est trouvée, de façon connue, dans le contenu de l'accumulateur au moment où arrive l'impulsion de débordement de fréquence $F_{Sj}$ fournie sur la sortie C du circuit accumulateur 2. Si on suppose que le rapport des fréquences

$$\frac{F_c}{F_S}$$

est supérieur à $2^n$, les n-1 premiers bits correspondant aux bits de poids fort de l'accumulateur sont toujours nuls lorsque arrive la retenue, cette remarque permet de les négliger et de prendre en compte seulement les k bits suivants qui représentent la fraction de période

$$\frac{1}{F_C}$$

dans laquelle bouge l'horloge $F_{Sj}$. Cette information numérique est utilisée par le dispositif de l'invention pour décaler l'horloge impulsionnelle $F_{Sj}$ qui est toujours en retard de phase. Pour cela les k bits d'erreur sont convertis par le convertisseur numérique analogique 2 qui fournit une tension $V = V0 - AR$ à partir de la référence de courant 5a du circuit représenté à la figure 3 en désignant par R le reste utile de l'accumulateur. Pendant ce temps le signal de retenue $F_{Sj}$ est appliqué à l'entrée de mise à 1 de la bascule D du générateur de rampe 4 référencé par la source de courant 5b. La mise à 1 de la bascule D,25 commande le blocage du transistor à effet de champ 26 et la charge du condensateur 28 à courant constant par la source de courant 5b de la façon qui est représentée sur le diagramme de la figure 4. La rampe qui apparaît aux bornes du condensateur 28 ainsi que la tension V issue du circuit de différence 24 sont introduites respectivement sur les première et deuxième entrées du circuit 6 de comparaison de tension qui élabore une impulsion lorsque les deux tensions coïncident. Cette impulsion $F_S$ est à la même fréquence que la fréquence $F_{Sj}$ et est décalée en avance selon la valeur de R. Le rebouclage de la sortie du circuit de comparaison sur l'entrée d'horloge de la bascule D permet à l'apparition de l'impulsion $F_S$ la remise à zéro de la bascule D et le déblocage du transistor à effet de champ 26 pour remettre à zéro le générateur de rampe en déchargeant la capacité 28 au travers du transistor 26. Le système qui vient d'être décrit permet par conséquent de corriger les décalages $\Delta\varnothing_0$, $\Delta\varnothing_1$, $\Delta\varnothing_2$ etc... sur la figure 4 de l'impulsion de retenue de l'accumulateur 2 et cela en faisant travailler le convertisseur numérique analogique une seule fois par impulsion, ce qui permet soit d'utiliser des convertisseurs numériques analogiques 2 fois plus lents que les méthodes de l'art connu, soit encore de synthétiser des horloges deux fois plus rapides.

Les impulsions ainsi délivrées sont épurées de toutes les raies parasites non harmoniques et peuvent être utilisées directement comme référence de phase dans une boucle de synthèse de fréquence soit encore être filtrées de leurs harmoniques, selon l'application envisagée, par une mise en forme.

La présente invention permet par conséquent déliminer dans une très large mesure les raies parasites selon la formule connue

$$S_{dB_c} = -20 \log_{10} \left( \frac{F_c}{F_s} - 6 \times K \right) \qquad (1)$$

où $S_{dBc}$ est le niveau des raies les plus hautes non harmoniques en dessous de la raie à la fréquence $F_s$, fréquence synthétisée ;

$F_c$ est la fréquence de l'horloge de base de l'accumulateur et K est le nombre de bits du convertisseur.

En prenant comme application type, une application nécessitant la synthèse de fréquences au voisinage autour de $10 \times 2^{19}$ Hertz ,soit 5, 24287 mégahertzs en dessous au pas de 10 hertz avec une horloge $F_c = 10 \times 2^{23}$ hertz $= 83,88608$ mégahertz. Dans cette application l'accumulateur fait 23 bits. Le rapport

$$\frac{F_c}{F_s}$$

est toujours supérieur à $2^4$ et par conséquent les 3 bits de poids fort sont négligés pour effectuer les corrections. En prenant les douze bits suivants pour effectuer la correction et un convertisseur de 12 bits, ce convertisseur devra répondre à $\pm\frac{1}{2}$ LSB, LSB désignant le bit le moins significatif en moins de 190 nanosecondes ce qui est réalisé couramment avec les technologies actuels. Dans cet exemple, la plage de correction des impulsions est de 11,9 nanosecondes, par conséquent, il suffit d'avoir une bonne linéarité durant cette faible période. Autour de la fréquence précitée les raie non harmoniques sont de l'ordre de -96 dBc.

De plus, si la rampe a une forte pente, de l'ordre de 100 Volts microsecondes et si le comparateur est très rapide, réalisé par exemple en technologie ECL, du type de ceux utilisés pour les convertisseurs analogiques numériques connus sous la désignation "convertisseur flash", on obtient des niveaux de bruit de phase en sortie de l'ordre de -139 dBc /Hz. Un autre avantage du circuit qui vient d'être décrit est que l'utilisation d'une référence de courant identique et de même sens pour le générateur de rampe et le convertisseur numérique analogique permet une bien meilleure invariance du réglage des corrections en fonction des variations climatiques, ce qui est fondamental étant donné les niveaux de raies atteints.

Dans les exemples cités le convertisseur numérique analogique 3 reçoit 12 bits qui sont les bits b8 à b19, dans le cas où la fréquence maximale, avec l'horloge $F_c$ à $10 \times 2^{23}$ hertz, est voisine de $10 \times 2^{19}$ par valeurs inférieures. Ceci permet de limiter les raies parasites résiduelles à -96 dB/c.

Cependant le dispositif qui vient d'être décrit ne vérifie la relation (1), dès que l'on s'écarte trop de la fréquence voisine par valeur inférieure de

$$\frac{F_c}{2^n}$$

pour lesquelles le synthétiseur prédédemment décrit est réalisé,n étant un entier positif.

Pour rendre effective la correction des décalages de temps quelque soient les fréquences il convient d'exprimer en durée l'erreur de phase fournie par le dispositif accumulateur (2) qui peut s'écrire suivant la relation

$$\Delta \varphi = \frac{2 \pi R}{Mod} \qquad (2)$$

R représentant le contenu du circuit accumulateur 2 et Mod représentant le Modulo de l'accumulateur, par l'expression

$$\Delta t = \frac{R}{Mod} \times \frac{1}{F_s} \qquad (3).$$

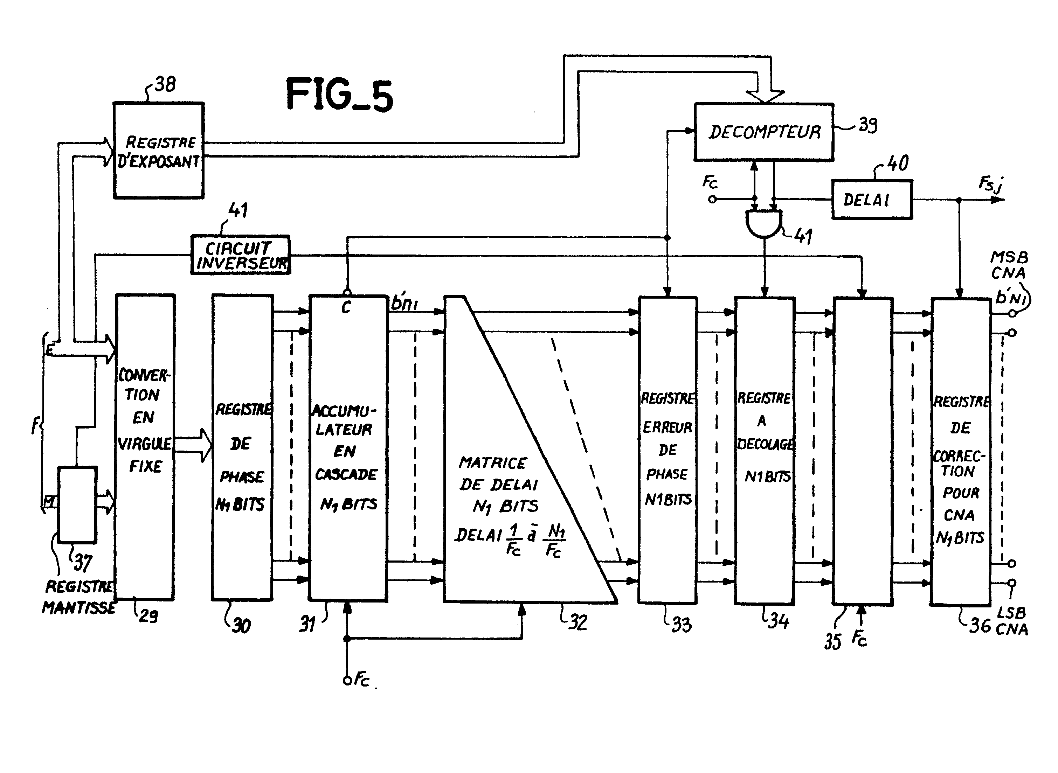

Pour cela le circuit accumulateur doit être modifié pour former le dispositif de calcul représenté à la figure 5. Le circuit accumulateur qui est représenté à la figure 5 comprend un convertisseur à virgule fixe 29, un registre de phase 30, un ensemble 31 de circuits accumulateurs constitués par les éléments représentés à la figure 2, une matrice de délai 32, un registre de phase 33, un registre à décalage 34, un circuit multiplieur 35 et un registre de correction 36, l'ensemble de ces éléments étant reliés dans cet ordre en série. Il comprend également un registre d'exposant 38, un décodeur 39 et un circuit retardateur 40. Le circuit 34 effectue le décalage automatique décrit ci-dessus, des bits à fournir au convertisseur. Le nombre de décalage à effectuer est égal au nombre de bits nuls pour les poids forts de l'incrément de phase, c'est-à-dire à la partie entière de

$$\log_2 \frac{F_c}{F_s}.$$

Pour faciliter ces opérations, il est préférable de présenter la fréquence à synthétiser dans un format flottant binaire exprimé en fraction de l'horloge $F_c$. Cette fréquence $F_s$ peut s'écrire sous la forme d'un nombre F en virgule flottante comprenant d'une mantisse M et un exposant E qui sont appliqués à l'entrée du convertisseur en virgule fixe 29 pour fournir dans un format fixe sur $N_1$ bits l'incrément de phase, l'exposant E étant mémorisé dans le registre d'exposant 38. Cet incrément de phase de $N_1$ bits est ensuite mémorisé dans le registre de phase 30 pour alimenter le circuit accumulateur 31 dont la structure est identique à celle représentée à la figure 2. Comme sur la figure 2, le circuit accumulateur 31 effectue ces opérations d'accumulation à la fréquence $F_c$ et donne un résultat sur $N_1$ bits. Les $N_1$ bits sortant du circuit accumulateur sont introduits dans la matrice à décalage 32 qui est elle-même pilotée à la fréquence $F_c$. Les $N_1$ bits qui sortent de la matrice à décalage 32 sont échantillonnés dans le registre 33 par le signal de débordement fourni par la sortie C du circuit accumulateur 31 qui représente la fréquence $F_{sj}$ du signal synthétisée non corrigée. Les $N_1$ bits sont ensuite chargés dans le registre à décalage 34 qui est un registre à décalage de $N_1$ bits fonctionnant à la fréquence $F_c$. Le registre à décalage 34 est commandé par la sortie de la porte ET 41 qui valide les signaux du générateur d'horloge 1 de fréquence $F_c$ en fonction du contenu du décompteur 39. Le contenu du décompteur 39 est initialisé à chaque impulsion $F_{sj}$ par la valeur de l'exposant qui est mémorisé dans le registre d'exposant 38 et cette valeur est décomptée au rythme de la fréquence Fc. Par conséquent le décalage des bits dans le registre à décalage 34 s'arrête à chaque fois que le contenu du décompteur 39 est nul. Le contenu du registre à décalage 34 est ensuite transféré dans le registre de correction 36 du convertisseur numérique analogique 3 au travers d'un circuit multiplieur 35. Ce circuit multiplieur 35 reçoit sur une première entrée d'opérande les bits fournis par le registre à décalage 34 et sur une deuxième entrée d'opérande les bits fournis par un opérateur qui a pour fonction de calculer l'inverse de la mantisse M, 41 couplé au registre 37. Ceci résulte du fait que la correction qui doit être appliquée est une correction qui est inversement proportionnelle à la fréquence synthétisée et qu'il faut pour chaque résidu utile réaliser l'opération

$$\frac{R}{F_s}.$$

Il s'avère que pour chaque fréquence synthétisée $F_s$ correspondant à un nombre F, le résidu R lors d'une retenue, c'est-à-dire, lors d'une impulsion $F_{sj}$ fournie par la sortie C du circuit accumulateur 31, est majoré par

7

$R \leqq F-1$

par conséquent $\Delta T$ est majoré suivant la relation

$$\Delta t \leqslant \frac{F-1}{Mod} \times \frac{1}{F_S}$$

comme $\frac{F}{Mod} = \frac{F_S}{F_C}$, la relation

$$\Delta t \leqslant \frac{1}{F_C} \times \frac{F-1}{F} \leqslant \frac{1}{F_C} \text{ est vérifiée.}$$

La gigue de phase est par conséquent majorée par

$$\frac{1}{F_C}$$

quelle que soit la fréquence à synthétiser et il apparaît bien que la correction à appliquer est inversement proportionnelle à la fréquence synthétisée et qu'il faut par conséquent pour chaque résidu utile réaliser l'opération $\frac{R}{F}$.

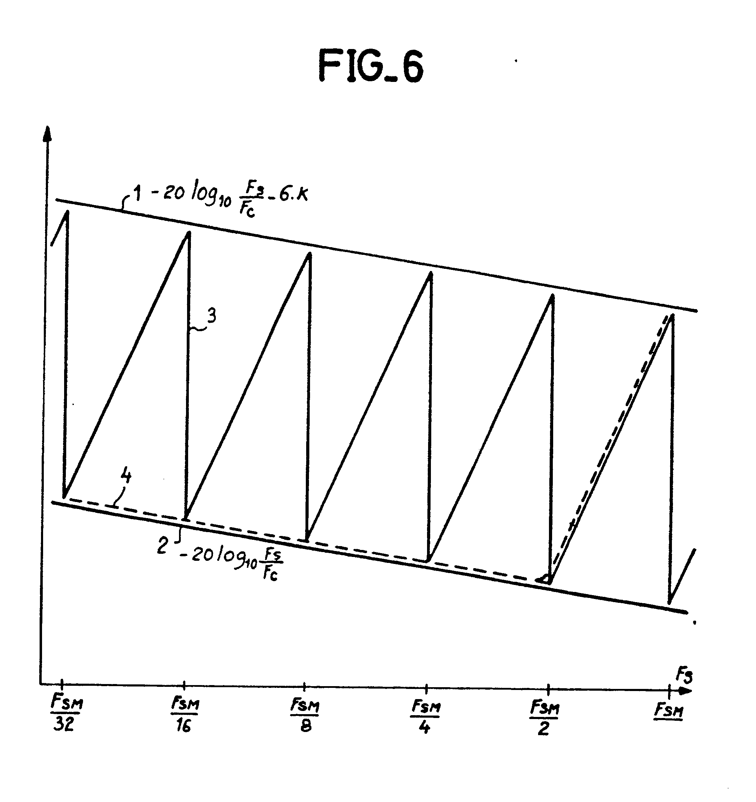

La représentation, sur la figure 6, des niveaux des raies résiduelles en présence de correction et sans correction permet de vérifier l'efficacité de celles-ci. Sans correction en fréquence avec un réglage de correction correspondant à la fréquence synthétisée maximale il apparaît que les corrections se dégradent progressivement selon la courbe représentée en (4). Avec une correction à l'octave près, c'est-à-dire en ne corrigeant F qu'avec l'exposant E de sa représentation flottante, l'équation (1) n'est optimisée qu'une fois par octave et la courbe du niveau des raies résiduelles est celle qui est représentée en (3). Avec une correction à l'intérieur d'une octave en tenant compte de la mantisse M de l'incrément de fréquence on optimise pour toutes les fréquences les corrections et on réalise l'équation (1) dont la représentation graphique correspond à la courbe (1) sur la figure 6. Pour cela il suffit de réaliser l'opération $\frac{R'}{M}$ avec autant de bits pour M que sur $R'$, $R'$ étant la transformée de R par le registre 34. On dispose là encore, pour effectuer cette opération de l'intervalle entre deux retenues, soit

$$\frac{1}{F_S}$$

ce qui est commode pour la multiplication. Comme le multiplieur 35 introduit un délai supplémentaire dans le calcul et que ce délai est constant, la fréquence $F_{Sj}$ est retardée pour assurer sa coïncidence avec les bits $b'_i$ par le circuit à retard 40.

Pour augmenter les performances du circuit multiplieur 34 il sera possible de choisir également pour ce circuit une structure de réseau systolique ou pipe line, la vitesse apparente sera plus grande bien que le délai du circuit reste le même. Egalement dans le mode de réalisation de la figure 5, l'opérateur 41 pourrait être réalisé d'une façon simple à l'aide d'une mémoire morte de capacité relativement faible cela représenterait 6 K octets pour une mantisse de 12 bits.

**Revendications**

1. Synthétiseur numérique de fréquence à corrections apériodiques optimalisant la pureté spectrale à grande précision temporelle caractérisé en ce qu'il comprend :

EP 0 230 826 B1

- un générateur (1) de signaux d'horloge de référence de fréquence $F_c$
- un dispositif de calcul (2) qui à partir d'un incrément de fréquence du signal à synthétiser fournit d'une part, des impulsions de fréquence $F_{sj}$ non corrigées décalées dans le temps par rapport au signal de fréquence $F_s$ à synthétiser d'une quantité $\Delta t$ au plus égale à $1/F_c$ et d'autre part, un signal d'erreur de temps correspondant au décalage de temps $\Delta t$ et un circuit de correction (3, 4, 5, 6) couplé au dispositif de calcul (2) pour retarder les impulsions de signal $F_{sj}$ d'une durée maximale lorsque le signal d'erreur de temps est nul et d'une quantité égale à la durée maximale diminuée du décalage $\Delta t$ indiqué par le signal d'erreur de temps, ledit dispositif de calcul comprenant au moins un registre accumulateur, incrémenté à pas constant à la fréquence de référence $F_c$, les impulsions de fréquence $F_{sj}$ étant obtenues sur la sortie de débordement du registre accumulateur chaque fois que la capacité maximale du registre accumulateur est atteinte, et ayant une sortie (D) pour initialiser après chaque instant de débordement le circuit de correction (3, 4, 5, 6) par le contenu du registre accumulateur représentant à cet instant le signal d'erreur de temps.

2. Synthétiseur selon la revendication 1, caractérisé en ce que l'incrément est appliqué en numérique au dispositif de calcul en virgule flottante sous la forme d'une mantisse et d'un exposant, l'incrément étant transmis au registre accumulateur au travers d'un convertisseur en virgule fixe (29), un registre de phase (30) et le contenu du registre accumulateur étant transmis en direction du circuit de correction au travers d'une matrice de délai (32), d'un registre d'erreur de phase (33), d'un registre à décalage (34), d'un circuit multiplieur (35) et d'un registre de correction (36), l'ensemble des éléments étant reliés dans cet ordre en série.

3. Synthétiseur selon la revendication 2, caractérisé en ce que le circuit multiplieur (35) effectue la multiplication du contenu du registre à décalage (34) avec l'inverse de la mantisse de l'incrément appliqué à l'entrée du dispositif de calcul.

4. Synthétiseur selon l'une quelconque des revendications 1 à 3, caractérisé en ce que le circuit de correction comprend :
   - un convertisseur numérique analogique (3) couplé au dispositif de calcul pour convertir sous forme analogique l'erreur de temps.
   - un générateur de rampe (4) déclenché par le signal de fréquence non corrigé obtenu à la sortie de débordement du registre accumulateur (2, 31)
   - et un circuit comparateur de tension (6) couplé par une première entrée à la sortie du générateur de rampe (4) et par une deuxième entrée à la sortie du convertisseur numérique analogique (3) au travers d'un circuit de calcul de différence (24) entre une tension de référence déterminée et la tension fournie par la sortie du convertisseur numérique analogique (3) représentant l'erreur de temps, le générateur de rampe (4) étant remis à zéro par la sortie du circuit comparateur (6) lorsqu'une égalité de tension est détectée par le circuit comparateur (6) entre le niveau de sortie du générateur (41) de rampe et le niveau de sortie du circuit de calcul de différence (24).

5. Synthétiseur selon l'une quelconque des revendications 1 à 4, caractérisé en ce que le registre accumulateur (2, 31) est composé d'accumulateurs élémentaires de 1 bit reliés en cascade selon une structure de réseau systolique ou pipe line.

6. Synthétiseur selon l'une quelconque des revendications 2 et 3, caractérisé en ce que le circuit multiplieur (35) a une structure de réseau systolique.

7. Synthétiseur numérique de fréquences élevées à correction apériodiques optimalisant la pureté spectrale caractérisé en ce qu'il comprend :
   - un générateur (1) de signaux d'horloge de référence de fréquence $F_c$
   - un registre accumulateur (2) incrémenté à pas constant à la fréquence de référence $F_c$ du générateur de signaux d'horloge ayant une sortie de débordement (C) pour fournir le signal d'horloge synthétisé non corrigé ($F_{sj}$),
   - un convertisseur numérique analogique (3) couplé au circuit accumulateur (2) pour convertir sous forme analogique l'erreur de temps contenue dans le circuit accumulateur après chaque débordement à pente constante,
   - un générateur de rampe (4) déclenché par le signal de fréquence non corrigé,

9

- et un circuit comparateur de tension (6) couplé par une première entrée à la sortie du générateur de rampe (4) et par une deuxième entrée à la sortie du convertisseur numérique analogique (3) au travers d'un circuit de calcul de différence entre une tension de référence (24) déterminée et la tension fournie par la sortie du convertisseur numérique analogique (3) représentant l'erreur de temps, le générateur de rampe étant remis à zéro par la sortie du circuit comparateur (6) lorsque une égalité de tension est détectée par le circuit comparateur (6) entre le niveau de sortie du générateur de rampe (4) et le niveau de sortie du circuit de calcul de différence (6), la sortie dudit comparateur fournissant le signal synthétisé de fréquence $F_s$.

## Claims

1. A digital aperiodic correction frequency synthesizer for optimizing spectral purity with a high temporal precision, characterized in that it comprises:
   - a reference clock signal generator (1) with a frequency of $F_c$,
   - a calculating device (2) which on the basis of an increment of the frequency to be synthesized on the one hand supplies uncorrected frequency pulses $F_{sj}$, which are shifted in time in relation to the signal with the frequency $F_s$ to be synthesized by a quantity $\Delta t$ at the most equal to $1/F_c$ and on the other hand a correction circuit (3, 4, 5 and 6) coupled with the calculating device (2) in order to delay the signal pulses $F_{sj}$ of a maximum duration when the time error signal is zero and of a quantity equal to the maximum duration diminished by the shift $\Delta t$ indicated by the time error signal, the said calculating device comprising at least one accumulator register, incremented with a constant step at the reference frequency $F_c$, the pulses with the frequency $F_{sj}$ being obtained at the overflow output of the accumulator register each time that the maximum capacity of the register is reached, and having an output (D) in order to initialize, after each overflow, the correction circuit (3, 4, 5 and 6) by the contents of the accumulator register representing the time error signal at this instant.

2. The synthesizer as claimed in claim 1, characterized in that the increment is applied digitally to the calculating device with a floating comma in the form of a mantissa and an exponent, the said increment being transmitted to the accumulator register through at least one fixed comma converter (29), a phase register (30) and the contents of the accumulator being fed to the correction circuit through a delay matrix (32), through a phase error register (33), through a shift register (34), through a multiplying circuit (35) and through a correction register (36), these elements being connected together in series in this order.

3. The synthesizer as claimed in claim 2, characterized in that the multiplying circuit (35) performs the multiplication of the contents of the shift register (34) with the inverse of the mantissa of the increment applied to the input of the calculating device.

4. The synthesizer as claimed in any one of the preceding claims 1 through 3, characterized in that the correction circuit comprises:
   - a digital analog converter (3) coupled with the calculating device in order to convert the time error into an analog form,
   - a ramp generator (4) triggered by the uncorrected frequency signal obtained at the overflow output of the accumulator register (2 and 31),
   - and a voltage comparison circuit (6) coupled via a first input with the output of the ramp generator (4) and by a second input with the output of the digital analog converter (3) through a difference calculating circuit (24) between a predetermined reference voltage and the voltage supplied by the output of the digital analog converter (3) representing the time error, the ramp generator (4) being zeroized by the output of the comparison circuit (6) when equal voltage levels are detected by the comparison circuit (6) at the output of the ramp generator (41) and the output of the difference calculating circuit (24).

5. The synthesizer as claimed in any one of the preceding claims 1 through 4, characterized in that the accumulator register (2 and 31) is made up of 1 bit elementary accumulators connected in series in accordance with a systolic or pipeline network structure.

6. The synthesizer as claimed in claim 2 and claim 3, characterized in that the multiplying circuit (35) has a systolic network structure.

7. A digital high frequency aperiodic correction synthesizer for optimizing spectral purity, characterized in that it comprises:
   - a reference clock signal generator (1) with a frequency $F_c$,
   - an accumulator register (2) incremented at a constant step at the reference frequency $F_c$ of the clock signal generator having an overflow output (C) in order to supply the uncorrected synthesized clock signal ($F_{sj}$),
   - a digital analog converter (3) coupled with the accumulator circuit (2) in order to convert the time error contained in the accumulator circuit into a an analog form after each overflow at a constant slope,
   - a ramp generator (4) triggered by the uncorrected frequency signal,
   - and a voltage comparison circuit (6) coupled by a first input with the output of the ramp generator (4) and by a second input with the output of the digital analog converter (3) through a difference calculating circuit between a given reference voltage (24) and the voltage provided by the output of the digital analog converter (3) representing the time error, the ramp generator being zeroized by the output of the comparison circuit (6) when the comparison circuit detects voltage equality between the output level of the ramp generator (4) and the output level of the difference calculating circuit (6), the output of the said comparison circuit supplying the synthesized signal with the frequency $F_s$.


## Ansprüche

1. Digitaler Frequenzsynthesator mit aperiodischen Korrekturen zur Optimierung der spektralen Reinheit mit hoher zeitlicher Genauigkeit, dadurch gekennzeichnet, daß er umfaßt:
   - einen Generator (1) für Referenztaktsignale der Frequenz $F_c$,
   - eine Recheneinrichtung (2), die aufgrund einer Inkrementierung der Frequenz des zu synthetisierenden Signals einerseits nicht korrigierte Impulse der Frequenz $F_{sj}$, die in bezug auf das zu synthetisierende Signal der Frequenz $F_s$ um einen Wert $\Delta t$, der höchstens gleich $1/F_c$ ist, zeitlich verschoben sind, und andererseits ein der Zeitverschiebung $\Delta t$ entsprechendes Zeitfehlersignal liefert, und eine Korrekturschaltung (3, 4, 5, 6), die mit der Recheneinrichtung (2) verbunden ist, um die Impulse des Signals $F_{sj}$ dann, wenn das Zeitfehlersignal null ist, um eine maximale Zeitdauer und sonst um einen Wert, der gleich der um die durch das Zeitfehlersignal angezeigte Verschiebung $\Delta t$ verringerten maximalen Zeitdauer ist, zu verzögern, wobei die Recheneinrichtung wenigstens ein Akkumulatorregister umfaßt, das mit der Referenzfrequenz $F_c$ in konstanten Schritten inkrementiert wird, wobei die Impulse der Frequenz $F_{sj}$ am Überlaufausgang des Akkumulatorregisters jedesmal dann erhalten werden, wenn die maximale Kapazität des Akkumulatorregisters erreicht ist, und das einen Ausgang (D) besitzt, um die Korrekturschaltung (3, 4, 5, 6) nach jedem Zeitpunkt des Überlaufs mit dem Inhalt des Akkumulatorregisters, der zu diesem Zeitpunkt das Zeitfehlersignal darstellt, zu initialisieren.

2. Synthesator gemäß Anspruch 1, dadurch gekennzeichnet, daß das Inkrement in die Recheneinrichtung gleitpunktmäßig in Form einer Mantisse und eines Exponenten digital eingegeben wird, wobei das Inkrement an das Akkumulatorregister über einen Festpunktumsetzer (29) und ein Phasenregister (30) übertragen wird und der Inhalt des Akkumulatorregisters in Richtung der Korrekturschaltung über eine Verzögerungsmatrix (32), ein Phasenfehlerregister (33), ein Schieberegister (34), eine Multiplikatorschaltung (35) und ein Korrekturregister (36) übertragen wird, wobei die Gesamtheit der Elemente in dieser Reihenfolge hintereinander geschaltet sind.

3. Synthesator gemäß Anspruch 2, dadurch gekennzeichnet, daß die Multiplikatorschaltung (35) die Multiplikation des Inhalts des Schieberegisters (34) mit dem Inversen der Mantisse des Inkrements, das an den Eingang der Recheneinrichtung gegeben wird, ausführt.

4. Synthesator gemäß einem der Ansprüche 1 bis 3, dadurch gekennzeichnet, das die Korrekturschaltung umfaßt:
   - einen Digital/Analog-Umsetzer (3), der mit der Recheneinrichtung verbunden ist, um den Zeitfehler in eine analoge Form umzuwandeln,
- einen Impulsflankengenerator (4), der durch das nicht korrigierte Frequenzsignal, das am Überlaufausgang des Akkumulatorregisters (2, 31) erhalten wird, ausgelöst wird,
- und eine Spannungsvergleichsschaltung (6), die an einem ersten Eingang mit dem Ausgang des Impulsflankengenerators (4) und an einem zweiten Eingang über eine Schaltung zur Berechnung der Differenz (24) zwischen einer gegebenen Referenzspannung und der am Ausgang des Digital/Analog-Umsetzers (3) gelieferten Spannung, die den Zeitfehler darstellt, mit dem Ausgang des Digital/Analog- Umsetzers (3) verbunden ist, wobei der Impulsflankengenerator (49 durch die Ausgabe der Vergleichsschaltung (6) auf null zurückgestellt wird, wenn von der Vergleichsschaltung (6) zwischen dem Ausgangspegel des Impulsflankengenerators (41) und dem Ausgangspegel der Differenzberechnungsschaltung (24) eine Spannungsgleichheit festgestellt wird.

5. Synthesator gemäß einem der Ansprüche 1 bis 4, dadurch gekennzeichnet, daß das Akkumulatorregister (2, 31) aus 1-Bit-Elementarakkumulatoren, die kaskadenartig entsprechend der Struktur eines systolischen Gitters oder einer Pipeline verbunden sind, aufgebaut ist.

6. Synthesator gemäß einem der Ansprüche 2 und 3, dadurch gekennzeichnet, daß die Multiplikatorschaltung (35) die Struktur eines systolischen Gitters besitzt.

7. Digitaler Hochfrequenzsynthesator mit aperiodischen Korrekturen zur Optimierung der spektralen Reinheit, dadurch gekennzeichnet, daß er umfaßt:
- einen Generator (1) von Referenztaktsignalen der Frequenz $F_c$,
- ein Akkumulatorregister (2), das mit der Referenzfrequenz $F_c$ des Taktsignalgenerators in konstanten Schritten inkrementiert wird, wobei der Taktsignalgenerator einen Überlaufausgang (C) besitzt, um das nicht korrigierte, synthetisierte Taktsignal (Fsj) zu liefern.
- einen Digital/Analog-Umsetzer (3), der mit der Akkumulatorschaltung (29 verbunden ist, um den in der Akkumulatorschaltung enthaltenen Zeitfehler nach jedem Überlauf mit konstanter Steilheit in eine analoge Form umzuwandeln,
- einen Impulsflankengenerator (4), der durch das nicht korrigierte Frequenzsignal ausgelöst wird,
- und eine Spannungsvergleichsschaltung (6), die an einem ersten Eingang mit dem Impulsflankengenerator (4) und an einem zweiten Eingang über eine Schaltung zur Berechnung der Differenz zwischen einer gegebenen Referenzspannung (24) und der vom Ausgang des Digital/Analog-Umsetzers (3) gelieferten Spannung, die den Zeitfehler darstellt, mit dem Ausgang des Digital/Analog-Umsetzers (39 verbunden ist, wobei der Impulsflankengenerator durch die Ausgabe der Vergleichsschaltung (69 auf null zurückgestellt wird, wenn von der Vergleichsschaltung (6) zwischen dem Ausgangspegel des Impulsflankengenerators (4) und dem Ausgangspegel der Differenzberechnungsschaltung (6) eine Spannungsgleichheit festgestellt wird, wobei der Ausgang der Vergleichsschaltung das synthetisierte Signal der Frequenz $F_s$ liefert.

# FIG_1

# FIG_3

FIG_2

# FIG_4

EP 0 230 826 B1

FIG_5

38 REGISTRE D'EXPOSANT

39 DECOMPTEUR

40 DELAI $F_{sj}$

$F_c$

41 CIRCUIT INVERSEUR

41

MSB CNA $b'_{N1}$

37 REGISTRE MANTISSE

29 CONVERTION EN VIRGULE FIXE

30 REGISTRE DE PHASE $N_1$ BITS

31 ACCUMULATEUR EN CASCADE $N_1$ BITS

$c$ $b'_{N1}$

32 MATRICE DE DELAI $N_1$ BITS DELAI $\frac{1}{F_c}$ à $\frac{N_1}{F_c}$

33 REGISTRE ERREUR DE PHASE N1BITS

34 REGISTRE A DECOLAGE N1BITS

35 $F_c$

36 REGISTRE DE CORRECTION POUR CNA $N_1$ BITS

LSB CNA

$F_c$

EP 0 230 826 B1

# FIG_6

$1 - 20 \log_{10} \dfrac{F_s}{F_c} - 6 \cdot K$

$3$

$4$

$2 - 20 \log_{10} \dfrac{F_s}{F_c}$

$\dfrac{F_{SM}}{32}$   $\dfrac{F_{SM}}{16}$   $\dfrac{F_{SM}}{8}$   $\dfrac{F_{SM}}{4}$   $\dfrac{F_{SM}}{2}$   $F_{SM}$

$F_S$